(19) Europäisches Patentamt
European Patent Office
Office européen des brevets

(11) **EP 3 582 269 B1**

(12) **EUROPEAN PATENT SPECIFICATION**

(45) Date of publication and mention
of the grant of the patent:
**07.10.2020 Bulletin 2020/41**

(51) Int Cl.:
*H01L 31/08* (2006.01)     *H01L 31/10* (2006.01)
*H01L 31/112* (2006.01)     *H01L 31/113* (2006.01)

(21) Application number: **19173544.8**

(22) Date of filing: **09.05.2019**

(54) **SENSOR FOR ELECTROMAGNETIC RADIATION OF MICROWAVE AND TERAHERTZ FREQUENCIES**

SENSOR FÜR ELEKTROMAGNETISCHE STRAHLUNG IM FREQUENZBEREICH VON MIKROWELLE BIS TERAHERTZ

CAPTEUR DE RAYONNEMENT ÉLECTROMAGNÉTIQUE HYPERFRÉQUENCES ET TÉRAHERTZ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.06.2018 LT 2018524**
          **07.11.2018 LT 2018547**

(43) Date of publication of application:
**18.12.2019 Bulletin 2019/51**

(73) Proprietor: **Valstybinis Moksliniu Tyrimu Institutas Fiziniu**
**Ir Technologijos Mokslu Centras**
**02300 Vilnius (LT)**

(72) Inventors:
• **SUZIEDELIS, Algirdas**
  **04207 Vilnius (LT)**
• **ASMONTAS, Steponas**
  **08411 Vilnius (LT)**
• **GRADAUSKAS, Jonas**
  **10308 Vilnius (LT)**
• **STEIKUNIENE, Angele**
  **08109 Vilnius (LT)**
• **STEIKUNAS, Gytis Julius**
  **08109 Vilnius (LT)**
• **ANBINDERIS, Maksimas**
  **13282 Vilnius (LT)**

(74) Representative: **Draugeliene, Virgina Adolfina**
**Tarpine Ltd**
**A. P. Kavoliuko g. 24-152**
**04328 Vilnius (LT)**

(56) References cited:
• **S. AS?MONTAS ET AL: "Submicron semiconductor structure for microwave detection", MICROELECTRONIC ENGINEERING., vol. 53, no. 1-4, 1 June 2000 (2000-06-01), pages 553-556, XP055557738, NL ISSN: 0167-9317, DOI: 10.1016/S0167-9317(00)00376-2**
• **ITO HIROSHI: "Broadband terahertz-wave detector implementing zero-biased InGaAsP Schottky-barrier diode", VISUAL COMMUNICATIONS AND IMAGE PROCESSING; 20-1-2004 - 20-1-2004; SAN JOSE,, vol. 9483, 13 May 2015 (2015-05-13), pages 948307-948307, XP060052915, DOI: 10.1117/12.2182741 ISBN: 978-1-62841-730-2**

**Description**

Technical field to which invention relates

The invention relates to the field of semiconductor electronic devices and is concerned with semiconductor sensors of electromagnetic radiation. Specifically, the invention relates to sensing and power measurement of both continuous wave (CW) and pulsed radiation of microwave and terahertz frequencies.

The proposal describes sensor of CW and pulsed radiation of microwave and terahertz frequencies which can be used to detect radiation, measure its power, and also investigate its modulated pulse shape. Such electromagnetic radiation sensors can be applied in waveguides, other transmission lines, or to investigate distribution of the electric field of microwave and terahertz frequencies in open space using single sensors or sensor arrays.

Indication of the background art

One of the ways to measure power of electromagnetic radiation of microwave and terahertz frequencies is to use hot carrier phenomena in semiconductors under strong electric field of the radiation. Such sensors, when compared with other devices of this purpose, have advantages such as ability to withstand high radiation power and to maintain the stability of electrical parameters for a long time. The fundamental physical principles of operation allow such sensors to operate in a wide spectral range of electromagnetic radiation as well as to detect short radiation pulses since their operating speed is limited by the carrier momentum and the carrier energy relaxation times which in usual semiconductor materials are of picosecond timescale.

The first design of such sensors was an ohmic semiconductor point contact with a metal probe connected to it. Due to the non-uniform distribution of the electric field, an electromotive force resulting from the non-uniform carrier heating is induced across the structure. However, such a design does not allow to use the point contact sensors in the range of high frequency electromagnetic waves due to inevitable limitation resulting from the need to reduce of the sensor's geometric dimensions.

This problem was solved by using a planar sensor design when both of its terminals were located on the same plane. In this way, the three-dimensional sensor structure was replaced by a two-dimensional one, and semiconductor technology allows to produce electronic devices having dimensions smaller than the wavelength of extremely-high frequency (EHF) microwaves and even terahertz radiation. In the asymmetrically narrowed planar homogeneous semiconductor structure, a bigradient electromotive force is induced due to non-uniform carrier heating under the action of electromagnetic radiation.

The closest analogue is the microwave and terahertz electromagnetic radiation sensor containing a semiconductor planar bow-tie shaped structure asymmetrically broadening from the center to the opposite sides, where one side of the structure broadens more sharply than the opposite side, thereby forming a sharply broadening part and a gradually broadening part of the sensor, where the said planar bow-tie shaped structure comprises a semiconductor base having a homogeneous semiconductor active region defined by the sharply broadening part and the rest of the structure of heavier doped semiconductor, doped at least by two orders in magnitude heavier as compared with the doping level of the active region, defined by the gradually broadening part and the part extending outwardly the sharply broadening part both covered with metal layer thus having ohmic contact formed between it and the heavily doped semiconductor region (S. Ašmontas, J. Gradauskas, A. Sužiedelis, G. Valušis, Submicron semiconductor structure for microwave detection, Microelectronic Engineering, Vol. 53, No. 1-4, p.553-556, 2000).

Such a two-dimensional structure is functionally close to the three-dimensional point contact sensor structure.

The sensor has a fundamental disadvantage: it has low voltage-power responsivity, i.e. the ratio of induced electromotive force to the incident radiation power. The responsivity of the analogue theoretically is expressed as follows:

$$S = \frac{U}{P_i} = \frac{\rho_n \mu_0}{hd^2 \ln(a/d)} N \, . \tag{1}$$

Here U is the electromotive force [V], $P_i$ is the power of incident radiation [W], $\rho_n$ stands for the resistivity of the active part of the sensor [$\Omega \cdot$m], $\mu_0$ indicates the carrier mobility [m$^2$ $\cdot$V$^{-1}$ $\cdot$s $^{-1}$], $h$ is the thickness of the planar semiconductor structure [m], $d$ is the width of the narrowest part of the structure [m], a is the maximum width of the sensor perpendicular to its symmetry axis [m], N is the term dependent on other parameters of the semiconductor material (electron momentum and energy relaxation times, Maxwell relaxation time, index of the dependence of electron momentum time on energy), radiation frequency, portion of the sensor-absorbed energy in respect of the incident energy.

According to equation (1), the responsivity can be improved by:

- choosing a semiconductor of higher resistivity,
- choosing a semiconductor with higher carrier mobility,
- making thinner structure,
- making narrower the narrowest part of the structure.

It should be noted that all these factors at the same time influence the resistance of the sensor, what may cause difficulties in matching it with a waveguide impedance. Another way to increase the responsivity of the asymmetrically narrowed sensor is to use various bandgap semiconductor hetero-junctions in the sharply active part thus forming two-dimensional electron gas layers (2DEG layers) with extremely high charge mobility at low temperatures (D. Seliuta, E. Sirmulis, V. Tamosiunas, S. Balakauskas, S. Asmontas, A. Suziedelis, J. Gradauskas, G. Valusis, A. Lisauskas, H.G. Roskos, and K. Kohler. Detection of Terahertz/Sub-terahertz Radiation by Asymmetrically-Shaped 2DEG Layers. Electron Lett., Vol. , No. 10, p. 631-632, 2004). This method significantly reduces electrical resistance of the sensor and significantly increases the amount of electromagnetic energy absorbed by the sensor. The shortcoming of this method is the necessity to cool the sensor down to liquid nitrogen or even lower cryogenic temperatures in order to reach significant increase in carrier mobility and thus in responsivity.

Document "Broadband Terahertz-Wave Detector Implementing Zero-Biased InGaAsP Schottky-Barrier Diode" (Hiroshi Ito et Al., Proc. of SPIE vol 9483 948307) describes a Terahertz detector with a bow.tie shaped antenna and an integrate schottky diode.

Technical problem to be solved

The invention aims to increase the responsivity of the microwave and terahertz radiation sensor.

Disclosure of invention

In order to solve the above problem, according to the proposed sensor of electromagnetic radiation of microwave and terahertz frequency, comprising a bow-tie shaped semiconductor planar structure asymmetrically broadening from the center to opposite sides, wherein one side of the structure broadens more sharply than the opposite side, thereby forming a sharply broadening part and a gradually broadening part of the sensor, said planar bow-tie shaped structure comprises a semiconductor base containing a semiconductor active region defined by the sharply broadening part and regions of heavier doped semiconductor, doped at least by two orders in magnitude heavier as compared with the doping level of the active region, which are defined by the gradually broadening part and at least by a part extending outwardly the sharply broadening part, the heavier doped semiconductor regions are covered with metal layer and an ohmic contact is formed between it and the heavily doped semiconductor regions, wherein the metal layer is extended inwardly to the center of the semiconductor active region above any end of the active region by partially covering it and forming a gate which has a non-ohmic contact with the part of the semiconductor active region beneath it.

The metal layer covering the part that extends the sharply broadening part to the outside is extended to the center of the active region above the wider end of the semiconductor active region thus overlapping it partially and forming a gate.

The metal layer covering the gradually broadening part to the outside is extended to the center of the active region above the narrower end of the semiconductor active region thus overlapping it partially and forming a gate.

The semiconductor base is made of homogeneous material or of various bandgap semiconductor layers.

The non-ohmic contact of said gate with the underlying part of the active region is a Schottky type semiconductor and metal contact.

The non-ohmic contact of said gate with the underlying part of the active region is of metal-insulator-semiconductor type.

Advantages of the invention

The sensor proposed according to the invention has significantly higher responsivity as compared to the analogues what is achieved by forming a metal layer, a gate, partially spanning the part of the semiconductor active region, and the gate has a Schottky type or metal-insulator-semiconductor type contact with the underlying part of the active region.

Such construction of the sensor provides conditions for higher radiation electric field gradient and for stronger inhomogeneous carrier heating and thus lets obtaining higher magnitude of the electromotive force at the same radiation power level.

Brief description of drawings

Fig.1 shows the sensor of electromagnetic radiation of microwave and terahertz frequencies with the gate formed above the wide end of the active region:

a) top view,

b) longitudinal cross-section view.

Fig.2 shows the sensor of electromagnetic radiation of microwave and terahertz frequencies with the gate formed above the narrow end of the active region:

a) top view,

b) longitudinal cross-section view.

Description of embodiments of the invention

The proposed sensor has a bow-tie shaped planar semiconductor structure asymmetrically broadening from the center to the opposite sides. One side of the structure broadens more sharply and forms a sharply broadening part 1 of the sensor, and other opposite side broadens gradually and forms a gradually broadening part 1a. The asymmetric semiconductor planar structure has a semiconductor base consisting of an active region which is made of homogeneous semiconductor material or of various bandgap semiconductor layers defined by a sharply broadening part 1, and of heavier doped semiconductor regions 2, doped at least by two orders in magnitude heavier as compared with the doping level of the active region, and defined by the gradually broadening part 1a together with its part extending outward along the longitudinal axis direction, and by the part 1b which extends the sharply broadening part 1 outwards along the longitudinal axis direction. The heavily doped semiconductor regions 2 are covered with a metal layer 3, and an ohmic contact 4 is formed between the metal 3 and the heavily doped semiconductor regions 2.

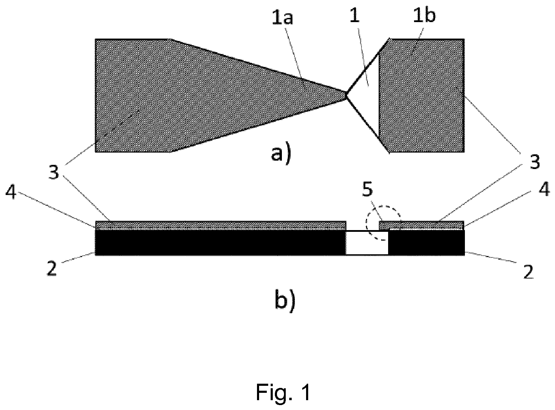

In Fig.1, the metal layer 3 covering the part 1b is extended to the center of the active region 1 over the wider end of the semiconductor active region 1 by partially covering it and forming a gate 5.

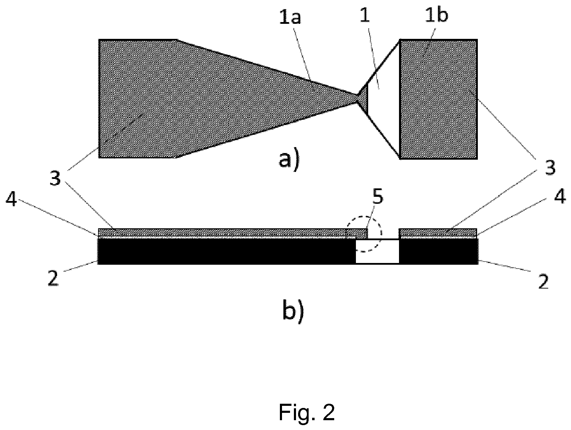

In Fig.2, the metal layer 3 covering the gradually broadening part 1a is extended to the center of the active region 1 over the narrower part of the semiconductor active region 1 by partially covering it and forming a gate 5.

In one embodiment of the sensor, the gate 5 forms a semiconductor and metal Schottky type contact with a part of the semiconductor active region 1 below it where the semiconductor of the active region 1 can optionally be homogeneous or consist of various bandgap semiconductor layers. Depending on the chosen base semiconductor material and herewith on the active region 1 homogeneous or layered semiconductor material, a metal of the layer 3 is appropriately chosen to form a Schottky-type semiconductor-metal contact. For example, if the homogeneous semiconductor of the active region 1 is silicon, then the metal of the layer 3 may be platinum. In other case, if the homogeneous semiconductor of the active region 1 is GaAs then Al or Pd are suitable as the layer 3 metals. Also, the semiconductor of the active region 1 may be layered, for example, composed optionally of GaAs and AlGaAs layers.

In another embodiment, the sensor gate 5 and the underlying part of the active region 1 below it have metal-insulator-semiconductor type contact. In this case, if the semiconductor of the active region 1 is Si, the insulator is usually $SiO_2$, and the metal may be gold. Other combinations may also be used. If the semiconductor of the active region 1 is GaAs, then the insulator may also be $SiO_2$ and the metal is gold. In this case, the semiconductor of the active region 1 may also be layered, for example, composed optionally of GaAs and AlGaAs layers.

The sensor for electromagnetic radiation of microwave and terahertz frequencies proposed in accordance with the invention is realized in one of the following ways.

During the fabrication of the asymmetrically narrowed bow-tie shaped planar semiconductor device, the electrical terminals, i.e. the metal layers 3 forming ohmic contacts 4 with the semiconductor parts 2, by means of semiconductor technology are covered with metal layer which covers the metal of the ohmic contact 4 and partly covers the wider or the narrower end of the sharply broadening semiconductor active region 1 by partially spanning it and forming the gate 5 which does not form an ohmic contact with the semiconductor and forms Schottky contact with the underlying part of the active semiconductor region 1.

During the fabrication of the asymmetrically narrowed bow-tie shaped planar semiconductor device, the surface of the sharply broadening semiconductor active region 1 is covered with a thin electric insulator layer by means of a semiconductor technology before the deposition of the metal layer 3; the heavier doped semiconductor region 2 is not covered with the insulator. Then, in a single technological stage, the metal is deposited both on the heavily doped semiconductor regions 2 to form the ohmic contacts 4 and on the insulator-coated part of the lightly doped active part 1 to form the gate 5.

When exposed to electromagnetic microwave or terahertz radiation, the electromotive force is generated across the sensor's electrical terminals. The gate gains the same electrical potential as it is of the integral metal terminal. This electrical potential changes the conditions of carrier heating by the electric field within the active semiconductor region 1. In this way, the sensor's voltage-power responsivity increases from several to several tens of times.

## Claims

1. Sensor for electromagnetic radiation of microwave and terahertz frequencies comprising a bow-tie shaped semiconductor planar structure asymmetrically broadening from the center to opposite sides, wherein one side of the structure broadens more sharply than the opposite one, thereby forming a sharply broadening region (1) and a gradually broadening region (1a), and said bow-tie shaped planar structure includes:
   a semiconductor base containing:

   a semiconductor active region defined by the sharply broadening part (1), and regions of heavier doped semiconductor (2), doped at least by two orders in magnitude heavier as compared with the doping of the active region (1), defined by the gradually broadening part (1a) and at least by a part (1b) extending outwardly the sharply broadening part (1),
   the heavier doped semiconductor regions (2) are covered with a metal layer (3), and an ohmic contact (4) is formed between it and the semiconductor regions (2), **characterized in that** the said metal layer (3) is extended inwardly to the center of the active region (1) above the any end of the semiconductor active region (1) by partially covering it and forming a gate (5) which has a non-ohmic contact with the part of the semiconductor active region (1) below it.

2. Sensor according to claim 1, **characterized in that** the metal layer (3) covering the part (1b) which extends the sharply broadening part (1) outwards is extended to the center of the active region (1) over the wider end of the semiconductor active region (1) by partially covering it and forming a gate (5).

3. Sensor according to claim 1, **characterized in that** the metal layer (3) covering the said gradually broadening part (1a) is extended to the center of the active region (1) over the narrower end of the semiconductor active region (1) by partially covering it and forming a gate (5).

4. Sensor according to any one of claims 1 to 3, **characterized in that** the base semiconductor is a homogeneous material or consists of various bandgap semiconductor layers.

5. Sensor according to any one of claims 1 to 4, **characterized in that** the non-ohmic contact of the gate (5) with the underlying part of the active region (1) is a Schottky type semiconductor and metal contact.

6. Sensor according to any one of claims 1 to 4, **characterized in that** the non-ohmic contact of the gate (5) with the underlying part of the active region (1) is of metal-insulator-semiconductor type.

## Patentansprüche

1. Sensor der elektromagnetischen Strahlung für Mikrowellen- und Terahertzfrequenzenstrahlung, der die planare Halbleiterstruktur in Form eines Schmetterlings umfasst, die vom Zentrum in die gegenseitigen Richtungen asymmetrisch sich verbreitet, wo eine Seite der Bildung plötzlicher als die andere ihre Gegenseite sich verbreitet und so den plötzlich sich zu verbreitenden Teil des Sensors (1) und einen langsam sich zu verbreitenden Teil (1a) zusammenbildet die vorerwähnte Planarstruktur in Form eines Schmetterlings umfasst:
   den Grund des Halbleiters, der beinhaltet:

   einen aktiven Bereich des Halbleiters, der durch den plötzlich sich zu verbreitenden Teil definiert wird (1), und die beidseits an seinen Enden angeordneten stärker, mindestens in zwei Reihen im Vergleich zu dem aktiven Bereich (1) legierten Bereiche des Halbleiters (2), die durch einen langsam sich zu verbreitenden Teil (1a) und wenigstens von dem Teil (1b), der den plötzlich sich zu verteilenden Teil (1) nach außen fortsetzt, definiert werden,

die gebildeten Bereiche eines stärker legierten Halbleiters (2) sind mit einer Metallschicht (3) bedeckt, zwischen deren und dem Bereich des Halbleiters (2) ein Ohmkontakt vorliegt (4), **dadurch gekennzeichnet, dass** die vorerwähnte Metallschicht (3) an einem ihrer Ende in der Mittelrichtung des aktiven Bereichs (1) über den aktiven Bereich (1) verlängert ist, wo die fortgesetzte Metallschicht (3) den aktiven Bereich (1) teilweise überdeckt und somit einen Gate (5) an diesem Ende bildet, der einen Nichtohmkontakt zu dem unter ihm sich zu befindenden Teil des aktiven Bereichs des Halbleiters (1) besitzt.

2. Sensor nach Anspruch 1, **dadurch gekennzeichnet, dass** die Metallschicht (3), die den Teil (1b) bedeckt, der den plötzlich sich zu verbreitenden Teil (1) nach außen verlängert, von einem aktiven Bereich (1) in der Mittelrichtung über dem breiten Ende des aktiven Bereichs des Halbleiters (1) verlängert ist und sie teilweise deckt sowie somit einen Gate (5) bildet.

3. Sensor nach Anspruch 1, **dadurch gekennzeichnet, dass** die Metallschicht (3), die den vorerwähnten langsam sich zu verbreitenden Teil (1a) deckt, von einem aktiven Bereich (1) in der Mittelrichtung über dem engen Ende des aktiven Bereichs des Halbleiters (1) verlängert ist und sie teilweise deckt sowie somit eine einen Gate (5) bildet.

4. Sensor nach einem der Ansprüche 1 bis 3, **dadurch gekennzeichnet, dass** der Halbleiter des Grundes aus einem homogenen Material hergestellt oder aus den verschiedenen zwischenräumigen Schichten der Halbleiter zusammengebildet ist.

5. Sensor nach einem der Ansprüche 1 bis 4, **dadurch gekennzeichnet, dass** der Nichtohmkontakt der vorerwähnten des Gates (5) mit dem unter ihm sich zu befindenden aktiven Bereich ein Zusammenstoß des Halbleiters des Typs Schottky und des Metalls (eine Metall-Halbleiter-Schottky- Barriere) ist.

6. Sensor nach einem der Ansprüche 1 bis 4, **dadurch gekennzeichnet, dass** der Nichtohmkontakt der vorerwähnten des Gates (5) mit dem unter ihm sich zu befindenden aktiven Bereich eines Typs Metall-Isolator-Halbleiter ist.

**Revendications**

1. Capteur de rayonnement électromagnétique dans des fréquences microondes térahertz comprenant d'une structure plane semi-conductrice en forme de nœud papillon s'élargissant asymétriquement du centre vers les côtés opposés, un des côtés s'élargit plus fortement que l'autre, formant ainsi une partie s'élargissant fortement (1) et l'autre progressivement (1a), ladite structure plane en forme de nœud papillon est formée par:
une base semi-conductrice comprenant de :

- une région active semi-conductrice définie par la partie fortement élargie (1), et de régions enrichies de semi-conducteurs (2), dopées a minima par deux fois plus de semi-conducteurs que dans la partie active (1), définie par l'élargisement de la partie (1a) et par une partie (1b) prolongeant vers l'extérieur la partie fortement élargie (1),
- les régions semi-conductrices, plus denses en semi-conducteurs (2), sont recouvertes d'une couche métallique (3), elles sont en contact ohmique (4) entre elle et les régions semi-conductrices (2), **caractérisé en ce que** couche métallique (3) étendue vers l'intérieur au centre de la ladite couche métallique (3) de la partie active (1) au-dessus de toute extrémité de la partie active semi-conductrice (1) en la re couvrant partiellement et en formant une grille (5) ayant un contact non ohmique avec la partie de la partie active semi-conductrice (1) inférieure.

2. Capteur selon la revendication 1, **caractérisé en ce que** la couche métallique (3) recouvrant la partie (1b) prolongeant la partie fortement élargie (1) vers l'extérieur et s'étend au centre de la partie active (1) sur l'extrémité la plus large de la partie active semi-conductrice (1) en la recouvrant partiellement et en formant une grille (5).

3. Capteur selon la revendication 1, **caractérisé en ce que** la couche métallique (3) recouvrant ladite partie et s'élargissant progressivement (1a) jusqu'au centre de la partie active (1) sur l'extrémité la plus étroite de la partie active semi-conductrice (1) en le recouvrant partiellement et en formant une grille (5).

4. Capteur selon l'une quelconque des revendications 1 à 3, **cataractérisé en ce que** le semi-conducteur de base est un matériau homogène ou est constitué de diverses couches semi-conductrices à bande hétérostructure.

**5.** Capteur selon l'une quelconque des revendications 1 à 4, **caractérisé par** le contact non ohmique de la grille (5) avec la partie sous-jacente de la partie active (1) qui est un contact semi-conducteur métallique de type Schottky.

**6.** Capteur selon l'une quelconque des revendications 1 à 4, **caractérisé en ce que** le contact non ohmique de la grille (5) avec la partie active sous-jacente (1) est de type métal-isolant-semi-conducteur.

a)

b)

Fig. 1

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. AŠMONTAS ; J. GRADAUSKAS ; A. SUŽIEDĖLIS ; G. VALUŠIS.** Submicron semiconductor structure for microwave detection. *Microelectronic Engineering,* 2000, vol. 53 (1-4), 553-556

- **D. SELIUTA ; E. ŠIRMULIS ; V. TAMOŠIUNAS ; S. BALAKAUSKAS ; S. AŠMONTAS ; A. SUŽIEDĖLIS ; J. GRADAUSKAS ; G. VALUŠIS ; A. LISAUSKAS ; H.G. ROSKOS.** Detection of Terahertz/Sub-terahertz Radiation by Asymmetrically-Shaped 2DEG Layers. *Electron Lett.,* 2004, 631-632
- **HIROSHI ITO et al.** Broadband Terahertz-Wave Detector Implementing Zero-Biased InGaAsP Schottky-Barrier Diode. *Proc. of SPIE,* vol. 9483, 948307